(19) **Europäisches Patentamt**
**European Patent Office**
**Office européen des brevets**

(11) **EP 3 660 520 B1**

(12) **EUROPEAN PATENT SPECIFICATION**

(45) Date of publication and mention
of the grant of the patent:
**31.03.2021 Bulletin 2021/13**

(51) Int Cl.:
*G01R 31/00* *(2006.01)*      *G01R 27/18* *(2006.01)*
*G01R 31/52* *(2020.01)*      *B60L 3/00* *(2019.01)*
*B60L 58/10* *(2019.01)*      *B60L 3/12* *(2006.01)*

(21) Application number: **18209536.4**

(22) Date of filing: **30.11.2018**

(54) **BATTERY MANAGEMENT SYSTEM FOR AN ELECTRIC VEHICLE WITH LEAKAGE RESISTANCE DETECTION**

BATTERIEVERWALTUNGSSYSTEM FÜR EIN ELEKTROFAHRZEUG MIT LECKWIDERSTANDSBESTIMMUNG

SYSTÈME DE GESTION DE BATTERIE D'UN VÉHICULE ÉLECTRIQUE AVEC DÉTERMINATION DE RÉSISTANCE DE FUITE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.06.2020 Bulletin 2020/23**

(73) Proprietor: **Munich Electrification GmbH
81373 Munich (DE)**

(72) Inventors:
• **Goede, Stefan
81373 Munich (DE)**
• **Goede, Stefan
80799 Munich (DE)**

• **Filgis, Simon
81675 Munich (DE)**
• **Reichmeyer, Konstantin
81371 Munich (DE)**

(74) Representative: **Grünecker Patent- und
Rechtsanwälte
PartG mbB
Leopoldstraße 4
80802 München (DE)**

(56) References cited:
**DE-A1-102016 103 883    US-A1- 2015 276 846
US-A1- 2017 334 295    US-B2- 8 884 638**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

**Description**

The present invention relates to a battery management system for an electric vehicle.

Electric vehicles use batteries with high voltages, for example 800 V DC or larger, in order to power an electric motor, which drives the vehicle. In order to ensure the safety of the electric vehicle's passengers and others that may come in contact with the electric vehicle, it has to be ensured that that the battery of the electric vehicle is sufficiently isolated from other vehicle structures. In particular, isolation must be ensured between the battery of the electric vehicle and the chassis of the electric vehicle, which serves as a grounding potential for other low voltage electric components.

In this context, electrical isolation of battery with a high voltage that is not continuously monitored must be 500 Ohm/V or greater. To ensure that, US 2013/0027049 A1 and CN 102508038 A suggest methods and devices for the determination of the leakage path resistance between a high voltage battery and the chassis of the vehicle.

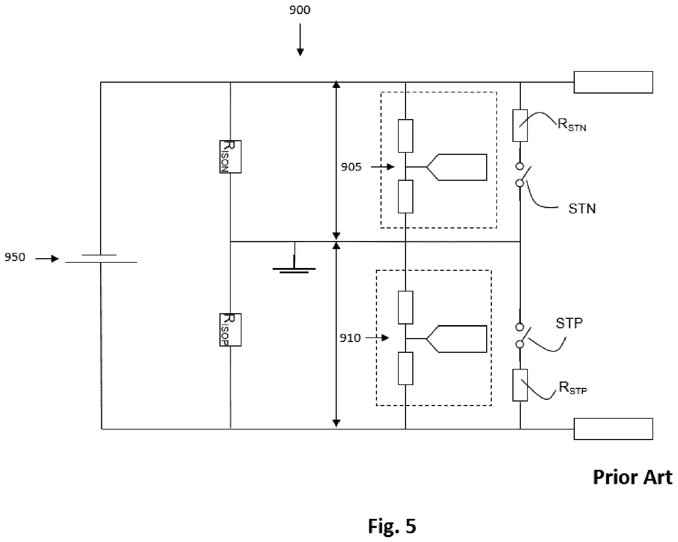

In particular, Fig. 5 shows a battery management system 900, which is conductively coupled to a battery 950. A voltage VN0 between the negative side of the battery 950 and the chassis of the vehicle is measured by the voltage divider 905 and a voltage VP0 between the positive side of the battery 950 and the chassis of the vehicle is measured by the voltage divider 910. If VN0 is greater than VP0, then it is given that the leakage path resistance $R_{ISON}$ on the negative side of the battery 950 is greater than the leakage path resistance $R_{ISOP}$ on the positive side of the battery 950. In the next step of the method, a known test resistance $R_{STN}$ is inserted between the negative side of the battery 950 and the chassis by turning the switch STN ON. Then VN1 is measured by the voltage divider 905 and $R_{ISOP}$ is calculated from the equation:

$$(1) \quad R_{ISOP} = R_{STN}(1+VP0/VN0)((VN0-VN1)/VN1)$$

Similarly, if VP0 is greater than VN0, a known test resistance $R_{STP}$ is inserted between the positive side of the battery 950 and the chassis by turning the switch STP ON. Next, VP1 is measured by the voltage divider 910 and $R_{ISON}$ is calculated from the equation:

$$(2) \quad R_{ISON} = R_{STP}(1+VN0/VP0)((VP0-VP1)/VP1)$$

In order to determine whether or not the leakage path resistance is large enough to meet the applicable standard, the calculated leakage path resistance, $R_{ISOP}$ or $R_{ISON}$, is divided by the voltage $V_{Bat}$ supplied by the battery 950 to the electric motor of the vehicle, and compared to the minimum acceptable leakage path resistance per volt.

However, devices configured for the determination of the leakage path resistance with such methods have multiple disadvantages. In order to measure the voltages VN and VP and in order to insert the test resistors $R_{STP}$ and $R_{STN}$, electric circuits are introduced by the battery management system 900 from the battery 950 to the chassis of the vehicle. Circuit components of these electric circuits have to fulfil high safety standards, so that the flexibility in selecting them is reduced. Furthermore, such circuit components enhance the risk of large leakage currents in the battery management system in case of malfunctions of one of such circuit components.

US 8 884 638 B2 discloses a circuit configuration for monitoring the electrical insulation of an electrically conductive part in relation to a first pole and a second pole of an electrical power network, for example an electrical drive network in a hybrid vehicle. The circuit configuration is characterized in that between the electrically conductive part and the two poles, a voltage divider having at least two resistors is arranged in each case. A measuring unit is associated with each of the two voltage dividers and provided for measuring a partial voltage, which drops via at least one of the resistors. A switch unit is associated each with the two voltage dividers and is provided for alternately bypassing at least one of the resistors.

US 2017/334295 A1 discloses a high voltage isolation tester, which has a high voltage side and a low voltage side coupled to each other by isolation amplifiers so that the high and low voltage sides are electrically isolated from each other. The high voltage side includes positive and negative high voltage test inputs and a common test input. The high voltage side also includes a positive switched voltage divider network and a negative switched voltage divider network. The low voltage side includes a controller that automatically controls switching of the switched voltage divider networks to make voltage measurements of voltages at inputs of the isolation amplifiers. Outputs of the isolation amplifiers are coupled to inputs of an analog-to-digital converter and the digitized voltages are read from the analog-to-digital converter by the controllei

DE 10 2016 103883 A1 discloses an electrified vehicle having first and second DC buses and a chassis ground. A leakage detector has a detector switch and detector resistor in series between the first bus and chassis ground. A voltage measured across the detector resistor is proportional to a leakage resistance between the second bus and chassis. An inverter has a plurality of phase legs, each having first and second phase switches coupled between the buses. An AC traction motor has phases coupled to the phase legs. An inverter control circuit receives data messages having a predetermined latency period from the detector identifying a measured leakage resistance. Switching events are detected during which a phase switch is closed for a duration greater than the latency period. An electrical short is indicated if the measured leakage resistance in a data message received during a detected switching event is less than a predetermined threshold.

US 2015/276846 A1 discloses a high voltage isolation measurement system. The isolation resistance value is determined by measuring the voltage across a set of high resistance resistor networks placed between the high voltage battery pack (both the positive and negative terminals) and the chassis ground and then modifying the resistance networks by switching in an additional high resistance network and repeating the measurements.

It is therefore an object of the present invention to provide a battery management system with a simplified circuit structure, additionally providing higher safety and a higher freedom in the selection of its circuit components. It is a further object to enable to produce a space-saving battery management system.

These objects are solved by the subject matter of the independent claim. Advantageous embodiments of the present invention are the subject matter of the dependent claims.

The present invention is based on the idea that a battery management system for an electric vehicle comprises a first terminal for electrically connecting one terminal of a battery of the electric vehicle, a second terminal for electrically connecting an electric load of the electric vehicle, a third terminal for electrically connecting a chassis of the electric vehicle. Further, the battery management system comprises a first determination circuit conductively coupled with a first node between the first terminal and the second terminal and conductively coupled with a second node to the third terminal. The first determination circuit comprises a first voltage divider, which comprises a first series circuit with at least a first resistor and a second resistor, a first switch which is conductively coupled in parallel to the first resistor and which is coupled between the first node and a node between the first resistor and the second resistor, so that, when the first switch is ON, the first resistor is short-circuited and that, when the first switch is OFF, the first resistor is not short-circuited, and a first measurement circuit configured to measure a first voltage across the second resistor, when the first switch is OFF, and to measure a second voltage across the second resistor, when the first switch is ON. Further, the battery management system comprises a processing circuit configured to determine a leakage path resistance between an other terminal of the battery and the chassis of the electric vehicle based on the first voltage and the second voltage, and a voltage of the battery.

According to an advantageous embodiment of the present invention, the processing circuit is further configured to control that the first switch is ON or OFF.

In other words, the present invention provides a battery management system with a first determination circuit, which comprises a first voltage divider and a first measuring circuit for measuring the voltage between one side of the battery and the chassis of the vehicle and a first switch for changing the resistance of the first determination circuit.

According to the present invention, the first switch is conductively coupled to one of the resistors comprised by the first voltage divider, thus enabling to change the resistance of the first voltage divider by switching the first switch.

In this way, it is possible to reduce the electric circuits introduced resistance by the battery management system from the battery to the chassis of the vehicle, and the present invention provides a simplified circuit structure. Additionally, this allows to produce a space saving battery management system and to reduce the production costs of the battery management system.

Additionally, by conductively coupling the first switch to the first resistor, it is ensured that the voltage applied across the first switch is reduced at least by the resistance of the second resistor. It is therefore possible to use a common solid state relay as a first switch, so that the space consumed by the battery management system is further reduced. Further, such a battery management system can be integrated on a single circuit board. This additionally allows to save space when installing the battery management system in the electric vehicle and to reduce production costs of the battery management system.

According to an advantageous embodiment of the present invention, the first series circuit further comprises a third resistor. Such a third resistor enables higher freedom in selecting the resistances of the first and second resistors comprised by the first voltage divider. Additionally, it is enabled by such a third resistor to limit the maximum voltage across the second resistor by appropriate selection of the third resistor. It is therefore possible to use commonly available analog-to-digital converter (ADCs) with reference voltages V < 5V DC as a first measurement circuit. Furthermore, the resistance of the third resistor can be selected high enough in order to protect the other circuit components of the first determination circuit from high currents, in particular during a "hi-pot" test procedure where high voltages (> 1000V DC) are applied across the first determination circuit.

According to an advantageous embodiment of the present invention the first series circuit further comprises a fourth resistor and the first determination circuit further comprises a second switch which is conductively coupled to the fourth resistor, so that, when the second switch is ON, the fourth resistor is short-circuited and that, when the second switch is OFF, the fourth resistor is not short-circuited, and the first measurement circuit is further configured to measure the first voltage across the second resistor when the first switch is OFF and when the second switch is OFF, and to measure the second voltage across the second resistor, when the first switch is ON and when the second switch is ON.

Hereby, a fourth resistor is conductively coupled in series with the first to third resistors. By conductively coupling a second switch to the fourth resistor, it is further possible to increase the changeable resistance of the first voltage divider, namely by the resistance of the fourth resistor, without risking that the voltages across both switches being too large, when at least one of the switches is OFF. Additionally, it is possible to improve the accuracy of the leakage path resistance determination.

According to an advantageous embodiment of the present invention, the battery management system further comprises a fourth terminal for electrically connecting the other terminal of the battery of the electric vehicle, a fifth terminal for electrically connecting the electric load of the electric vehicle and, a second determination circuit which is conductively coupled with a third node between the fourth terminal and the fifth terminal and conductively coupled with a fourth node to the third terminal. The second determination circuit further comprises a second voltage divider which comprises a second series circuit with at least a fifth resistor and a sixth resistor, a third switch which is conductively coupled to the fifth resistor, so that, when the third switch is ON, the fifth resistor is short-circuited and that, when the third switch is OFF, the fifth resistor is not short-circuited, a second measurement circuit configured to measure a third voltage across the sixth resistor, when the third switch is OFF, and to measure a fourth voltage across the sixth resistor, when the third switch is ON, and the processing circuit is further configured to determine a leakage path resistance between the one terminal of the battery and the chassis of the electric vehicle based on the third voltage and the fourth voltage.

According to an advantageous embodiment of the present invention, the processing circuit is further configured to control that the third switch is ON or OFF.

By incorporation of the second determination circuit, which is configured in accordance with the first determination circuit, it is possible to determine each leakage path resistance between the chassis of the electric vehicle and two different terminals of the battery. Furthermore, in this way, it is possible to provide a battery management system with a simplified circuit structure on both sides of the battery. This additionally allows to produce a space saving battery management system and to reduce the production costs of the battery management system.

According to an advantageous embodiment of the present invention, the second series circuit further comprises a seventh resistor. Such a seventh resistor enables higher freedom in selecting the resistances of the resistors comprised by the second voltage divider. Additionally, it is enabled by the seventh resistor to limit the voltage across the sixth resistor by appropriate selection of the seventh resistor. It is therefore possible to use commonly available analog-to-digital converter (ADCs) with reference voltages $V < 5V$ DC as a second measurement circuit. Furthermore, the resistance of the seventh resistor can be selected high enough in order to protect the circuit components of the second determination circuit from high currents, in particular during the "hi-pot" test procedure.

According to an advantageous embodiment of the present invention, the second series circuit further comprises an eighth resistor and the second determination circuit further comprises a fourth switch which is conductively coupled to the eighth resistor, so that, when the fourth switch is ON, the eighth resistor is short-circuited and that, when the fourth switch is OFF, the eighth resistor is not short-circuited, and the second measurement circuit is further configured to measure the third voltage across the sixth resistor, when the third switch is OFF and when the fourth switch is OFF, and to measure the fourth voltage across the sixth resistor, when the third switch is ON and when the fourth switch is ON.

Hereby, an eighth resistor is conductively coupled in series with the fifth to seventh resistors. By conductively coupling a fourth switch to the eighth resistor, it is further possible to increase the changeable resistance of the second voltage divider, namely the resistance of the eighth resistor, risking that the voltages across the switches of the second determination circuit are too large, when at least one of these switches is OFF. Additionally, it is possible to improve the accuracy of the leakage path resistance determination.

According to an advantageous embodiment of the present invention, the processing circuit is further configured to determine the leakage path resistance between the other terminal of the battery and the chassis of the electric vehicle based on the first voltage, the second voltage and the third voltage.

According to another advantageous embodiment of the present invention, the processing circuit is further configured to determine the leakage path resistance between the one terminal of the battery and the chassis of the electric vehicle based on the first voltage, the third voltage and the fourth voltage.

By using voltages measured with each one of the determination circuits, the processing circuit can determine a leakage path resistance between each terminal of the battery and the chassis without having further information of the voltage of the battery.

According to another embodiment of the present invention, the second measurement circuit is further configured to measure a fifth voltage across the sixth resistor, when the first switch is ON and/or when the second switch is ON, and the processing circuit is further configured to determine the leakage path resistance between the other terminal of the battery and the chassis of the electric vehicle based on the first voltage, the second voltage, the third voltage and the fifth voltage; and/or the first measurement circuit is further configured to measure a sixth voltage across the second resistor, when the third switch is ON and/or when the fourth switch is ON, and the processing circuit is further configured to determine the leakage path resistance between the one terminal of the battery and the chassis of the electric vehicle based on the first voltage, the third voltage, the fourth voltage and the sixth voltage.

By measuring the fifth voltage and the sixth voltage and using them for determining the respective leakage path resistances, such a determination becomes more accurate and does not depend anymore on the assumption of a constant battery voltage.

According to an advantageous embodiment of the present invention, the battery management system further comprises a first contactor conductively coupled with the first node to the first terminal and with an fifth node to the second terminal, and a second contactor conductively coupled with the third node to the fourth terminal and with a sixth node to the fifth terminal.

By the contactors provided by the battery management system, it is further possible to electrically separate the electric load of the vehicle from the battery.

According to an advantageous embodiment of the present invention, the second terminal is further configured for electrically connecting one side of a DC link of the electric vehicle, and the fifth terminal is further configured for electrically connecting an other side of the DC link of the electric vehicle, wherein the DC link is conductively coupled with the electric load of the electric vehicle, and the DC link comprises a first capacitance conductively coupled with a first node of the DC link between the second terminal and the electric load of the electric vehicle and with a second node of the DC link to the chassis of the electric vehicle, a second capacitance conductively coupled with a third node of the DC link between the fifth terminal and the electric load of the electric vehicle and with the second node of the DC link to the chassis of the electric vehicle, and a third capacitance which is conductively coupled with the first node of the DC link and with the third node of the DC link.

By this configuration it is further possible to conductively couple a DC link of the electric vehicle to the battery management system, wherein the DC link is conductively coupled with the electric load of the vehicle. This allows to determine a leakage path of the DC link to the vehicle chassis with a simple method and to further reduce the electric components of the battery management system.

According to an advantageous embodiment of the present invention, the battery management system further comprises a sixth terminal for electrically connecting one terminal of a low-voltage battery, the other terminal of the low voltage battery being conductively coupled to the chassis of the vehicle, a fifth switch conductively coupled with a seventh node to the sixth terminal and with the fifth node between the second terminal and the first contactor, and a third measurement circuit conductively coupled with the fifth node between the second terminal and the first contactor and with an eighth node to the third terminal configured to measure a seventh voltage between the fifth node and the eighth node, when the fifth switch is ON, wherein the processing circuit is further configured to control that the fifth switch is ON or OFF and to determine a leakage path resistance between the one side of the DC link and the chassis of the electric vehicle based on the seventh voltage.

In other words, the battery management system further comprises a fifth switch to conductively couple a low-voltage battery to the DC link of the vehicle and a third measurement circuit for measuring a voltage of the DC link.

In this manner, it is further possible that the battery management system can determine the leakage path resistance of at least one side of DC-Link to the vehicle chassis without applying high voltage from the battery of the vehicle to the DC-link. Thus, it is possible to determine the leakage path resistance of the DC link to the chassis of the vehicle before electrically connecting the high voltage battery of the vehicle to the DC link, in particular before starting the vehicle.

According to an advantageous embodiment of the present invention, wherein the first switch and/or the second switch and/or the third switch and/or the fourth switch and/or the fifth switch are solid state relays. Hence, it is further possible to fabricate a space-saving battery management system. Additionally, it is possible to integrate such a battery management system on a single chip, in order to save space when installing the battery management system and to reduce production costs of the battery management system significantly.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:

Fig. 1 is a schematic circuit diagram of a battery management system according to a first embodiment of the present invention.

**Fig. 2** is a schematic circuit diagram of a battery management system according to a second embodiment of the present invention.

**Fig. 3** is a schematic circuit diagram of a battery management system according to a third embodiment of the present invention.

**Fig. 4** is a schematic circuit diagram of a battery management system according to a fourth embodiment of the present invention.

**Fig. 5** is a schematic circuit diagram of a battery management system according to the prior art.

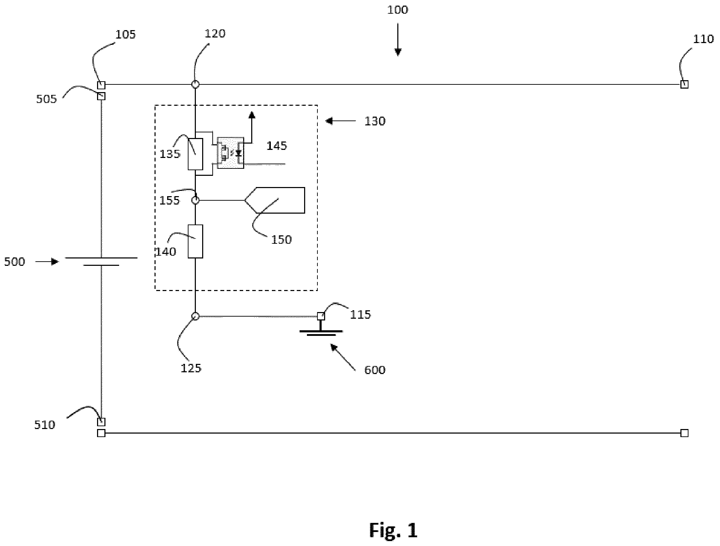

The present invention will now be explained in more detail with reference to the Figures and firstly referring to Fig. 1. Figure 1 is a schematic circuit diagram of a battery management system 100 that can benefit from the ideas according to a first embodiment of the present invention.

The battery management system 100 is configured for use in an electric or hybrid vehicle having a battery 500, which is isolated from the chassis 600 of the vehicle. Hereby, the term "electric vehicle" also includes hybrid electric vehicles and the term "battery" includes single battery packs as well as several battery packs connected in series. An electric vehicle, which is equipped with the battery management system 100, comprises an electric load, such as a DC/AC inverter, which is supplied with power from the battery 500 and supplies the electric motor of the vehicle with AC power. Alternatively, the electric load may be a DC/DC inverter, which supplies power to an DC/AC inverter or other electric components of the vehicle.

As shown in Fig. 1, the battery management system 100 comprises a first terminal 105 for electrically connecting one terminal 505 of the battery 500, a second terminal 110 for electrically connecting the electric load of the electric vehicle and a third terminal 115 for electrically connecting the chassis 600 of the electric vehicle. Hereby, the term "terminal" describes a point at which a conductor from an electric device, an electric circuit or an electric component ends, and where a point is provided for electrically connecting an external electric device, an external electric circuit or an external electric component to this conductor.

The battery management system 100 comprises a first determination circuit 130 conductively coupled with a first node 120 between the first terminal 105 and the second terminal 110 and with a second node 125 to the third terminal 115. The term "node" may refer to a point where the terminals of one or more circuit components meet or may refer to the entire wire, which conductively couples the terminals of one or more electric circuit components. The term "conductively coupled" describes the establishing of an electrical connection between the terminals of at least two circuit components, which allows the flow of (high power) electric current. For example, in a high voltage system, two electric circuits may be conductively coupled by a copper wire configured to conduct high currents.

The first determination circuit 130 comprises a first series circuit with at least a first resistor 135 and a second resistor 140, a first switch 145 and a first measurement circuit 150. Hereby, the first measurement circuit 150 is conductively coupled with a node 155 between the first resistor 135 and the second resistor 145, so that the first resistor 135 and the second resistor 140 form a first voltage divider. In this manner, a voltage between the first node 120 and the second node 125, and thus between the one terminal 505 of the battery 500 and the chassis of the vehicle 600 can be determined by the voltage measured by the first measurement circuit 150 across the second resistor 140, when the battery 500 is conductively coupled to the battery management system 100.

According to the present invention, the first determination circuit 130 further comprises the first switch 145, so as to enable to change the resistance of the first voltage divider. For this purpose, the first switch 145 is conductively coupled to the first resistor 135 in such a way that the first resistor 135 is short-circuited when the first switch 145 is ON and that the first resistor 135 is not short-circuited when the first switch 145 is OFF. As shown exemplarily in Fig. 1, this may be achieved by conductively coupling the first switch 145 in parallel to the first resistor 135, so that the first switch 145 is conductively coupled with the first node 120 and the node 155. Moreover, a person skilled in the art should understand that the term "short-circuiting" a resistor describes that a current flowing through the resistor is reduced by a factor of around 100 to 1000 or higher when the resistor is short-circuited, compared to the current flowing through the resistor when the resistor is not short-circuited.

Preferably, the first switch 145 may be realized by a solid state relay which comprises an infrared emitting diode, optically coupled to a photo-MOSFET. Such a photo-MOSFET comprises a source-drain path which is galvanically separated from the external control path through the relay. It is therefore possible to connect a processing circuit of the battery management system 100 in such a way that it controls the first switch 145 to be ON or OFF, without conductively coupling the processing circuit to the battery 500. Preferably, this may be realized by conductively coupling the infrared emitting diode of the solid state relay to the processing circuit of the battery management system 100, so that the processing circuit can control the solid state relay by triggering the infrared emitting diode with a current. It is clear for a skilled person, that when using such a solid state relay, the second resistance is selected accordingly, in order to avoid voltages across the solid state relay higher than its breakdown voltage (-600 V DC), when the solid state relay is OFF.

The processing circuit of the battery management system 100 is further configured to determine the leakage path resistance $R_{iso,2}$ between an other terminal 510 of the battery 500 and the chassis 600 of the electric vehicle based on a first voltage $V_{1,1}$ and a second voltage $V_{1,2}$ by the equation

$$(3) \quad R_{iso,2} = R_{ST1}\left(\frac{V_{bat}-V_{1,2}}{V_{1,2}} - \frac{V_{bat}-V_{1,1}}{V_{1,1}}\right)$$

Hereby, the first voltage $V_{1,1}$ is measured by the first measurement circuit 150 across the second resistor 140, when the first switch 145 is OFF, and the second voltage $V_{1,2}$ is measured by the first measurement circuit 150 across the second resistor 140, when the first switch 145 is ON. Further used for the determination of the leakage path resistance $R_{iso,2}$ is the voltage $V_{bat}$ of the battery 500 and the resistance $R_{ST1}$, which is the resistance of the first voltage divider when the first switch 145 is ON. For example, in the first embodiment of the battery management system 100, the resistance $R_{ST1}$ is equal to resistance of the second resistor 140.

As can be derived from equation (1), the processing circuit of the battery management system 100 further needs information about the voltage $V_{bat}$ of the battery 500 in order to determine an absolute value of the leakage path resistance $R_{iso,2}$. Without information about the battery voltage, however, the battery management system 100 can still determine the value of the parallel combination of the leakage path resistances $R_{iso,1}$ and $R_{iso,2}$, wherein $R_{iso,1}$ is the leakage path resistance between the other terminal 510 of the battery 500 and the chassis 600 of the electric vehicle. As the resistance of a parallel connection of resistors is always smaller than the resistance of each single resistor comprised by the parallel connection, it is possible in this way to estimate a minimum value for the leakage path resistances $R_{iso,1}$ and $R_{iso,2}$.

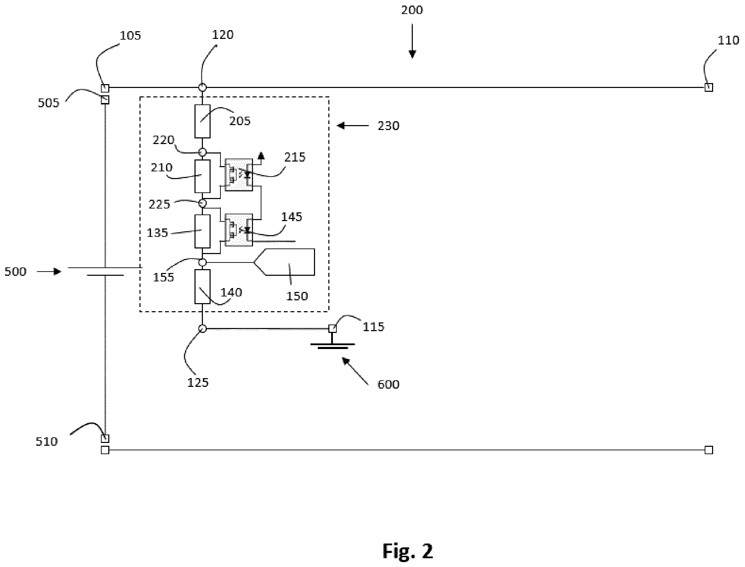

Figure 2 is a schematic circuit diagram of a battery management system 200 that can benefit from the ideas according to a second embodiment of the present invention. The battery management system 200 comprises the battery management system 100, wherein the series circuit of the first determination circuit 230 further comprises a third resistor 205, and optionally comprises a fourth resistor 210 and a second switch 215.

The third resistor 205 is conductively coupled with the first node 120 and with a node 220.

The fourth resistor 210 is conductively coupled with the node 220 to the third resistor 205 and a node 225 to the first resistor 135 and the first switch 145. It is clear for the skilled person, that the third resistor 205 can also be coupled with the node 220 to the first resistor 135 and the first switch 145, in case that the first series circuit does not comprise the fourth resistor 210 and the second switch 215.

The third resistor 205 is preferably selected high enough in order to not destroy the switches comprised by the first determination circuit 230 during a "hi-pot" test procedure, where high voltages (> 1000V DC) are applied across the first determination circuit 230. In an exemplary embodiment, the third resistor is selected to have a resistance of 2MOhm.

Moreover, such selection of the third resistor 205 enables a higher freedom in selecting the resistance of the second resistor 140 without risking large currents through the first determination circuit 230. For example, a 15 kOhm resistance may be selected for the second resistor 140, so that it is ensured that the voltage across the second resistor 140 does not exceed 5 V. In this manner, it is possible to use an analog-to-digital converter (ADC) with a reference voltage of 5V as the first measurement circuit 145.

The second switch 215 is conductively coupled to the fourth resistor 210 in such a way that the fourth resistor 210 is short-circuited when the second switch 215 is ON and that the fourth resistor 210 is not short-circuited when the second switch 215 is OFF. Preferably, this is achieved by conductively coupling the second switch 215 in parallel to the fourth resistor 210, so that the second switch 215 and the fourth resistor 210 are conductively coupled with the node 220 to the third resistor and a node 225 to the first resistor 135 and the first switch 145.

Preferably the resistance of the fourth resistor 210 is selected in such a way that the voltage across the first switch 145 and the voltage across the second switch 215 are distributed equally, when the first switch 145 is OFF and when the second switch 215 is OFF. In this way, it is guaranteed that both switches 145 and 215 can be opened safely. This might be achieved, for example, by selecting the resistance of the fourth resistor 210 equal to the resistance of the first resistor 135, for example a resistance of around 25MOhm is selected for both resistors 135 and 210.

In this context, it is clear for a person skilled in the art that all resistance values mentioned in this document are merely examples and that the same advantages effects can be achieved by varying the resistance values in a favorable way.

Furthermore, it is preferable to realize the second switch 215 by a solid state relay which comprises an infrared emitting diode optically coupled to a photo-MOSFET. In this manner, it is possible to conductively couple the processing circuit of the battery management system 200 to the second switch 215 in such a way that it controls the second switch 215 to be ON or OFF, without conductively coupling the processing circuit to the battery 500 of the electric vehicle. Thereby, the processing circuit can ensure, that the first voltage $V_{1,1}$ is measured across the second resistor 140 when the first switch 145 is OFF and when the second switch 215 is OFF, and that the second voltage $V_{1,2}$ is measured across the second resistor 140, when the first switch 145 is ON and when the second switch 210 is ON.

Moreover, it is obvious for a skilled person that the first terminal 105 of the battery management system 100 or 200 according to the first or second embodiment of the present invention may be alternatively electrically connected to the other terminal 510 of the battery 500 in order to determine the leakage path resistance from the one terminal 505 of the battery 500 to the chassis 600 of the electric vehicle.

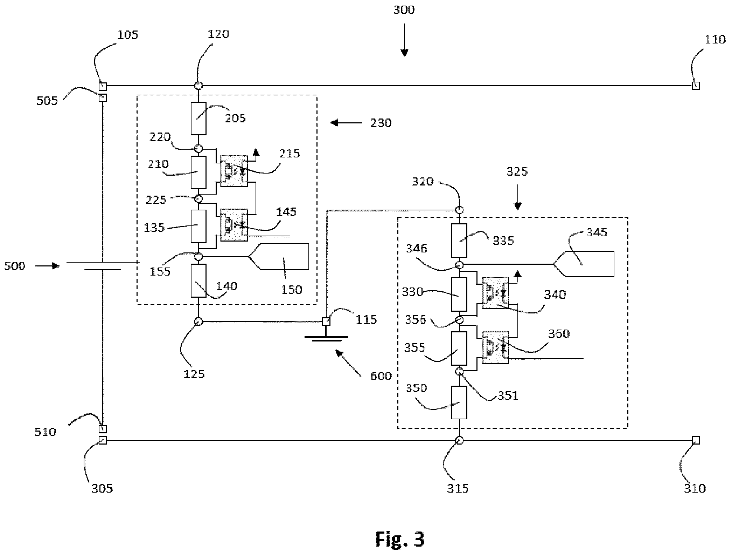

Figure 3 is a schematic circuit diagram of a battery management system 300 that can benefit from the ideas according to a third embodiment of the present invention. The battery management system 300 comprises the battery management system 200 and further comprises a fourth terminal 305 for electrically connecting the other terminal 510 of the battery 500 of the electric vehicle, a fifth terminal 310 for electrically connecting the electric load of the electric vehicle and a second determination circuit 325. The second determination circuit 325 is conductively coupled with a third node 315 between the fourth terminal 305 and the fifth terminal 310 and with a fourth node 320 to the third terminal 115.

Furthermore, the second determination circuit 325 is configured in accordance with the first determination circuit 230, thus providing the same advantages. In particular, advantages described for a specific circuit component of the first determination circuit 130 and 230 are also achieved in the second determination circuit 325 by the related circuit component of the second determination circuit 325. Hence, for the sake of simplicity, such advantages will not be repeated, but relate to the advantages described accordingly for the circuit components of the first determination circuits 130 and 230.

The second determination circuit 325 comprises a second series circuit with at least a fifth resistor 330 and a sixth resistor 335, a third switch 340 and a second measurement circuit 345. Hereby, the second measurement circuit 345 is conductively coupled with a node 346 in between the fifth resistor 330 and the sixth resistor 335 so that the fifth resistor 330 and the sixth resistor 335 form a first voltage divider. In this manner, a voltage between the third node 315 and the fourth node 320, and thus between the other terminal 510 of the battery 500 and the chassis of the vehicle 600 can be determined by the voltage measured by the second measurement circuit 345 across the sixth resistor 335, when the battery 500 is conductively coupled to the battery management system 100.

The third switch 340 is conductively coupled to the fifth resistor 330 in such a way that the fifth resistor 330 is short-circuited when the third switch 340 is ON and that the fifth resistor 330 is not short-circuited when the third switch 340 is OFF. As shown exemplarily in Fig. 1, preferably this is achieved by conductively coupling the third switch 340 in parallel to the fifth resistor 330, so that the third switch 340 is conductively coupled with the node 346 and the node 356.

Preferably, the third switch 340 may be realized by a solid state relay which comprises an infrared emitting diode optically coupled to a photo-MOSFET. In this manner, it is further possible to conductively couple the processing circuit of the battery management system 300 to the third switch 340 in such a way that it controls that the third switch 340 is ON or OFF, without conductively coupling the processing circuit to the battery 500 of the electric vehicle.

Optionally, the second determination circuit 325 also comprises a seventh resistor 350, and/or an eighth resistor 355 and a fourth switch 360. Hereby, technical advantages achieved by incorporating the seventh resistor 350 into the second determination circuit 325 relate to technical advantages achieved by incorporating the third resistor 205 in the first determination circuit 230. Similarly, technical advantages achieved by incorporating the eighth resistor 355 and the fourth switch 360 into the second determination circuit 325 relate to technical advantages achieved by incorporating the fourth resistor 210 and the second switch 215 in the first determination circuit 230.

The processing circuit of the battery management system 300 is further configured to determine the leakage path resistance $R_{iso,1}$ between the one terminal 505 of the battery 500 and the chassis 600 of the electric vehicle based on a third voltage $V_{2,1}$ and a fourth voltage $V_{2,2}$ by the equation

$$(4) \quad R_{iso,1} = R_{ST2}\left(\frac{V_{bat}-V_{2,2}}{V2,2} - \frac{V_{bat}-V_{2,1}}{V_{2,1}}\right).$$

Hereby, the third voltage $V_{2,1}$ is measured by the second measurement circuit 345 across the sixth resistor 335, when the third switch 340 is OFF and/or when the fourth switch 360 is OFF, and the fourth voltage $V_{2,2}$ is measured by the second measurement circuit 345 across the sixth resistor 335, when the third switch 340 is ON and/or when the fourth switch 360 is ON. Further used for the determination of the leakage path resistance $R_{iso,1}$ is the voltage $V_{bat}$ of the battery 500 and the resistance $R_{ST2}$, which is the resistance of the second serious circuit when the third switch 340 is ON and/or when the fourth switch 360 is ON.

In another example, the processing circuit of the battery management system 300 determines the leakage path resistances $R_{iso,1}$ and $R_{iso,2}$ by the equations

$$(5) \quad R_{iso,2} = R_{ST1}(1 + \frac{V_{2,1}}{V_{1,1}})(\frac{V_{1,1}-V_{1,2}}{V_{1,2}}),$$

and

$$(6) \quad R_{iso,1} = R_{ST2}(1 + \frac{V_{1,1}}{V_{2,1}})(\frac{V_{2,1}-V_{2,2}}{V_{2,2}}).$$

Hence, the processing circuit of the battery management system 300 can determine exact values of the leakage path resistances $R_{iso,1}$ and $R_{iso,2}$ without further information about the voltage $V_{bat}$ of the battery 500.

In another example, the processing circuit of the battery management system 300 determines the leakage path resistances $R_{iso,1}$ and $R_{iso,2}$ by the equations

$$(7) \quad R_{iso,2} = R_{ST1}(\frac{V_{2,3}}{V_{1,2}} - \frac{V_{2,1}}{V_{1,1}}),$$

and

$$(8) \quad R_{iso,1} = R_{ST2}(\frac{V_{1,3}}{V_{2,2}} - \frac{V_{1,1}}{V_{2,1}}).$$

Hereby, the fifth voltage $V_{2,3}$ is measured by the second measurement circuit 345 across the sixth resistor 335, when the first switch 145 is ON and when the third switch 340 is OFF and/or when the second switch 215 is ON and/or when the fourth switch 360 is OFF. Similarly, the sixth voltage $V_{1,3}$ is measured by the first measurement circuit 150 across the second resistor 140, when the first switch 145 is OFF and when the third switch 340 is ON and/or when the second switch 215 is OFF and/or when the fourth switch 360 is ON.

Moreover, it is clear for a skilled person, that the first voltage $V_{1,1}$ and the second voltage $V_{1,2}$ are preferably measured by the first measurement circuit 150 across the second resistor 140, when the third switch 340 is OFF and/or when the fourth switch 360 is OFF. Just as well, the third voltage $V_{2,1}$ and the fourth voltage $V_{2,2}$ are measured by the second measurement circuit 345 across the sixth resistor 335, when the first switch 145 is OFF and/or when the second switch 215 is OFF. In this manner, it can be prevented that the resistances $R_{ST1}$ and $R_{ST2}$ have erroneous influence on determining the leakage path resistances $R_{iso,1}$ and $R_{iso,2}$.

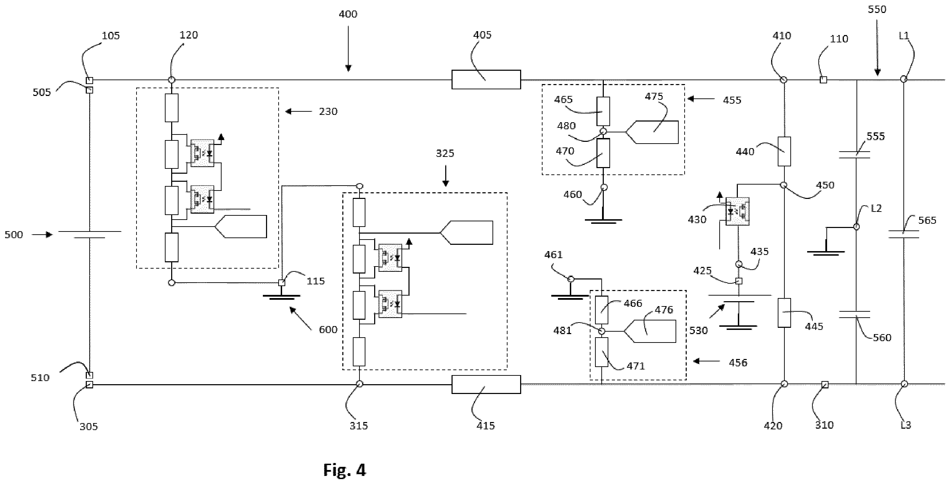

According to a fourth embodiment of the present invention, shown in Fig. 4, it is possible to determine the leakage path resistance of a DC link 550 which is electrically connected to the electric load of the electric vehicle. In particular, it is possible to determine the leakage path resistance of a DC link 550, when the DC link 550 is not electrically connected to the battery 500. Figure 4 is a schematic circuit diagram of a battery management system 400 that can benefit from the ideas according to the fourth embodiment of the present invention.

The battery management system 400 comprises the battery management system 300 and further comprises a first contactor 405 conductively coupled with the first node 120 to the first terminal 105 and with an eight node 410 to the second terminal 110, and a second contactor 415 conductively coupled with the third node 315 to the fourth terminal 305 and with an ninth node 420 to the fifth terminal 310.

Both contactors 405 and 415 are used for electrically disconnecting the battery 500 from the electric load of the electric vehicle. Hence, both contactors 405 and 410 are preferably designed for conducting high power currents when they are ON, while they are also designed for having high breakdown voltages (> 1000 V DC) when they are OFF. Furthermore, it is preferable that the processing circuit of the battery management system 400 controls that the contactors 405 and 415 are ON or OFF.

Fig. 4 shows that the second terminal 110 of the battery management system 400 is conductively coupled to one side of the DC link 550 and the fifth terminal 310 of the battery management system 400 is conductively coupled to an other side of the DC link 550. As shown by Fig. 4, the DC link 550 preferably comprises a first capacitance 555, a second capacitance 560 and a third capacitance 565.

Hereby, the first capacitance 555 is conductively coupled with a first node L1 of the DC link 550 between the second terminal 110 of the battery management system 400 and the electric load of the electric vehicle and with a second node L2 of the DC link 550 to the chassis 600 of the electric vehicle. The second capacitance 560 is conductively coupled with a third node L3 of the DC link 550 between the fifth terminal 310 of the battery management system 400 and the electric load of the electric vehicle and with the second node L2 of the DC link 550 to the chassis 600 of the electric vehicle. The third capacitance 565 is conductively coupled with the first node L1 of the DC link between the second terminal 110 of the battery management system 400 and the electric load of the electric vehicle and with the third node L3 of the DC link 550 between the fifth terminal 310 of the battery management system 400 and the electric load of the electric vehicle.

Furthermore, the battery management system 400 comprises a sixth terminal 425 for electrically connecting one terminal of a low voltage battery 530. For example, a 12 V auxiliary battery of the electric vehicle may be used as the low voltage battery 530. However, it is also possible to use another low voltage battery as the battery 530, under the condition, that an other terminal of the used low voltage battery is connected to the chassis of the electric vehicle.

A fifth switch 430 is conductively coupled with a seventh node 435 to the sixth terminal 425 and with the fifth node 410 between the second terminal 110 and the first contactor 405. Optionally, the fifth switch 430 is also conductively coupled with the sixth node 420 between the fifth terminal 310 and the second contactor 415. In this case, resistors 440 and 445 are conductively coupled with an additional node 450 to the fifth switch 430, wherein the resistor 440 is conductively coupled with the fifth node 410 and the resistor 445 is conductively coupled with the sixth node 420.

Preferably, both resistors 440 and 445 are selected to be large enough to protect the fifth switch 430 from high voltages when the fifth switch is OFF and when both the contactors 405 and 415 are ON. For this purpose, both resistors 440 and 445 may be selected to have resistances around 2 MOhm.

Hence, it is possible to realize the fifth switch 430 by a solid state relay which comprises an infrared emitting diode optically coupled to a photo-MOSFET. In this manner, it is further possible to conductively couple the processing circuit of the battery management system 400 to the fifth switch 430 in such a way that it controls that the fifth switch 430 is ON or OFF, without conductively coupling the processing circuit to the battery 500 of the electric vehicle, even when the contactors 405 and 415 are ON.

Furthermore, the battery management system comprises a third measurement circuit 455 conductively coupled with the fifth node 410 between the second terminal 110 and the first contactor 405 and conductively coupled with an eighth node 460 to the third terminal 115. The third measurement circuit 455 is configured to measure a seventh voltage between the fifth node 410 and the eighth node 460, when the fifth switch 430 is ON and when both the contactors 405 and 415 are OFF. Preferably, the third measurement circuit is realized by a third voltage divider, which comprises a resistor 465 and a resistor 470. Further, an ADC 475 is conductively coupled with a node 480 between the resistor 465 and the resistor 470. The resistor 465 may be selected to have a resistance of around 50 MOhm, so as to protect the third voltage divider from high power currents when both the contactors 405 and 415 are ON.

The processing circuit of the battery management system 400 is further configured to determine a leakage path resistance between the one side of the DC link 550 and the chassis of the electric vehicle based on the seventh voltage and by means of the voltage $V_{aux}$ of the low voltage battery 530.

Optionally, the battery management system 400 further comprises a fourth measurement circuit 456, conductively coupled with the sixth node 420 between the fifth terminal 310 and the second contactor 415 and conductively coupled with a ninth node 461 to the third terminal 115. The fourth measurement circuit 456 is configured to measure an eighth voltage between the sixth node 420 and the ninth node 461, when the fifth switch 430 is ON and when both the contactors 405 and 415 are OFF. Exemplarily, the fourth measurement circuit 456 includes a fourth voltage divider with a resistor 466 and a resistor 471. Further, an ADC 476 is conductively coupled with a node 481 between the resistor 466 and the resistor 471. Here, the resistor 471 may be selected to have a resistance of around 50 MOhm, so as to protect the fourth voltage divider from high power currents when both the contactors 405 and 415 are ON.

In case that the battery management system 400 comprises the fourth measurement circuit 456, the processing circuit of the battery management system 400 is further configured to determine a leakage path resistance between the other side of the DC link 550 and the chassis of the electric vehicle based on the seventh voltage and by means of the voltage $V_{aux}$ of the low voltage battery 530.

**List of reference signs**

| Reference sign | |
|:---:|:---:|
| 100, 200, 300, 400 | battery management system (BMS) |
| 105 | first terminal |
| 110 | second terminal |
| 115 | third terminal |
| 120 | first node |
| 125 | second node |

(continued)

| Reference sign | |
|---|---|
| 130, 230 | first determination circuit |
| 135 | first resistor |
| 140 | second resistor |
| 145 | first switch |
| 150 | first measurement circuit |
| 155, 220, 225 | nodes of the first determination circuit |
| 205 | third resistor |
| 210 | fourth resistor |
| 215 | second switch |
| 305 | fourth terminal |
| 310 | fifth terminal |
| 315 | third node |
| 320 | fourth node |
| 325 | second determination circuit |
| 330 | fifth resistor |
| 335 | sixth resistor |
| 340 | third switch |
| 345 | second measurement circuit |
| 346, 351, 356 | nodes of the second determination circuit |
| 350 | seventh resistor |
| 355 | eighth resistor |
| 360 | fourth switch |
| 405, 415 | contactors |
| 410, 420, 435, 450, 460, 461, 480, 481 | nodes oft the BMS 400 |
| 425 | sixth terminal |
| 430 | fifth switch |
| 440, 445, 465, 466, 470, 471 | resistors of the BMS 400 |
| 455 | third measurement circuit |
| 456 | fourth measurement circuit |
| 475, 476 | ADCs |
| 500 | battery of the electric vehicle |
| 505 | one terminal of the battery |
| 510 | other terminal of the battery |
| 530 | low voltage battery |
| 550 | DC-link of the electric vehicle |
| 555, 560, 565 | capacitors of the DC link |
| 600 | chassis of the electric vehicle |
| L1, L2, L3 | nodes of the DC link |

**Claims**

1.  A battery management system for an electric vehicle comprising:

    a first terminal (105) for electrically connecting one terminal (505) of a battery (500) of the electric vehicle,
    a second terminal (110) for electrically connecting an electric load of the electric vehicle,
    a third terminal (115) for electrically connecting a chassis (600) of the electric vehicle,
    a first determination circuit (130, 230) conductively coupled with a first node (120) between the first terminal (105) and the second terminal (110) and conductively coupled with a second node (125) to the third terminal (115), the first determination circuit (130, 230) comprising:
    a first voltage divider which comprises a first series circuit with at least a first resistor (135) and a second resistor (140); **characterised in that** the first determination circuit (130, 230) further comprises:

    a first switch (145) which is conductively coupled in parallel to the first resistor (135) and which is coupled between the first node (120) and a node (155) between the first resistor (135) and J Z the second resistor (145), so that, when the first switch is ON, the first resistor (135) is short-circuited and that, when the first switch (145) is OFF, the first resistor (135) is not short-circuited,
    a first measurement circuit (150) configured to measure a first voltage across the second resistor (140), when the first switch (145) is OFF, and to measure a second voltage across the second resistor (140), when the first switch (145) is ON;
    and wherein the battery management system further comprises:
    a processing circuit configured to determine a leakage path resistance between an other terminal (510) of the battery (500) and the chassis (600) of the electric vehicle based on the first voltage, the second voltage, and a voltage of the battery (500).

2.  The battery management system according to claim 1, wherein the processing circuit is further configured to control that the first switch (145) is ON or OFF.

3.  The battery management system according to any of claims 1 or 2, wherein the first series circuit further comprises a third resistor (205).

4.  The battery management system according to any of claims 1 to 3, wherein the first series circuit further comprises a fourth resistor (210) and the first determination circuit (230) further comprises a second switch (215) which is conductively coupled in parallel to the fourth resistor (210) and which is coupled between the first node (120) and a node (225) between the first resistor (135) and the fourth resistor (210), so that, when the second switch (215) is ON, the fourth resistor (210) is short-circuited and that, when the second switch (215) is OFF, the fourth resistor (210) is not short-circuited, and
    the first measurement circuit (145) is further configured to measure the first voltage across the second resistor (140) when the first switch (145) is OFF and when the second switch (215) is OFF, and to measure the second voltage across the second resistor (140), when the first switch (145) is ON and when the second switch (215) is ON.

5.  The battery management system according to any of claim 1 to 4, further comprising:

    a fourth terminal (305) for electrically connecting the other terminal (510) of the battery (500) of the electric vehicle,
    a fifth terminal (310) for electrically connecting the electric load of the electric vehicle and, a second determination circuit (325) which is conductively coupled with a third node (315) between the fourth terminal (305) and the fifth terminal (310) and conductively coupled with a fourth node (320) to the third terminal (115), the second determination circuit (325) further comprising:

    a second voltage divider which comprises a second series circuit with at least a fifth resistor (330) and a sixth resistor (335),
    a third switch (340) which is conductively coupled in parallel to the fifth resistor (330) and which is coupled between the third node (315) and a node (346) between the fifth resistor (330) and the sixth resistor (335), so that, when the third switch (340) is ON, the fifth resistor (330) is short-circuited and that, when the third switch (340) is OFF, the fifth resistor (330) is not short-circuited,
    a second measurement circuit (325) configured to measure a third voltage across the sixth resistor (335), when the third switch (340) is OFF, and to measure a fourth voltage across the sixth resistor (335), when the third switch (340) is ON, and

wherein the processing circuit is further configured to determine a leakage path resistance between the one terminal (505) of the battery (500) and the chassis (600) of the electric vehicle based on the third voltage, the fourth voltage and the voltage of the battery (500).

6. The battery management system according to claim 5, wherein the processing circuit is further configured to control that the third switch (340) is ON or OFF.

7. The battery management system according to any of claims 5 or 6, wherein the second series circuit further comprises a seventh resistor (350).

8. The battery management system according to any of claims 5 to 7, wherein the second series circuit further comprises an eighth resistor (355) and the second determination circuit (325) further comprises a fourth switch (360) which is conductively coupled in parallel to the eighth resistor (355) and which is coupled between the third node (315) and a node (356) between the fifth resistor (330) and the eighth resistor (355), so that, when the fourth switch (360) is ON, the eighth resistor (355) is short-circuited and that, when the fourth switch (360) is OFF, the eighth resistor (355) is not short-circuited , and
the second measurement circuit (345) is further configured to measure the third voltage across the sixth resistor (335), when the third switch (340) is OFF and when the fourth switch (360) is OFF, and to measure the fourth voltage across the sixth resistor (355), when the third switch (340) is ON and when the fourth switch (360) is ON.

9. The battery management system according to any of claims 5 to 8, wherein the processing circuit is further configured to determine the leakage path resistance between the other terminal (510) of the battery (500) and the chassis (600) of the electric vehicle based on the first voltage, the second voltage and the third voltage.

10. The battery management system according to any of claims 5 to 8, wherein the processing circuit is further configured to determine the leakage path resistance between the one terminal (505) of the battery (500) and the chassis (600) of the electric vehicle based on the first voltage, the third voltage and the fourth voltage.

11. The battery management system according to any of claims 5 to 8, wherein
the second measurement circuit (345) is further configured to measure a fifth voltage across the sixth resistor (335), when the first switch (145) is ON and/or when the second switch (215) is ON, and
the processing circuit is further configured to determine the leakage path resistance between the other terminal (510) of the battery (500) and the chassis (600) of the electric vehicle based on the first voltage, the second voltage, the third voltage and the fifth voltage; and/or
wherein the first measurement circuit (150) is further configured to measure a sixth voltage across the second resistor (140), when the third switch (340) is ON and/or when the fourth switch (360) is ON, and
the processing circuit is further configured to determine the leakage path resistance between the one terminal (505) of the battery (500) and the chassis (600) of the electric vehicle based on the first voltage, the third voltage, the fourth voltage and the sixth voltage.

12. The battery management system according to any of claims 1 to 11, further comprising a first contactor (405) conductively coupled with the first node (120) to the first terminal (105) and with a fifth node (410) to the second terminal (110), and a second contactor (410) conductively coupled with the third node (315) to the fourth terminal (305) and with a sixth node (420) to the fifth terminal (310).

13. The battery management system according to claim 12, wherein
the second terminal (110) is further configured for electrically connecting one side of a DC link (550) of the electric vehicle, and
the fifth terminal (310) is further configured for electrically connecting an other side of the DC link (550) of the electric vehicle,
wherein the DC link (550) is conductively coupled with the electric load of the electric vehicle and the DC link comprises:

a first capacitance (555) conductively coupled with a first node (L1) of the DC link (550) between the second terminal (110) and the electric load of the electric vehicle and with a second node (L2) of the DC link (550) to the chassis of the electric vehicle,
a second capacitance (560) conductively coupled with a third node (L3) of the DC link (550) between the fifth terminal (310) and the electric load of the electric vehicle and with the second node (L2) of the DC link (550) to the chassis of the electric vehicle, and
a third capacitance (565) which is conductively coupled with the first node (L1) of the DC link (550) and with the third node (L3) of the DC link (550).

14. The battery management system according to claim 13, further comprising:

a sixth terminal (425) for electrically connecting one terminal of a low voltage battery (530), the other terminal of the low voltage battery (530) being conductively coupled to the chassis of the vehicle,
a fifth switch (430) conductively coupled with a seventh node (435) to the sixth terminal (425) and with the fifth node (410) between the second terminal (110) and the first contactor (405), and
a third measurement circuit (455), conductively coupled with the fifth node (410) between the second terminal (110) and the first contactor (405) and with an eighth node (460) to the third terminal (115), configured to measure a seventh voltage between the fifth node (410) and the eighth node (460), when the fifth switch (430) is ON, wherein the processing circuit is further configured to control that the fifth switch (430) is ON or OFF and to determine a leakage path resistance between the one side of the DC link and the chassis of the electric vehicle based on the seventh voltage.

15. The battery management system according to any of claims 1-3, wherein the first switch (145) is a solid state relay, and/or according to claim 4 wherein the second switch (215) is a solid state relay, and/or according to any of claims 5-7 wherein the third switch (340) is a solid state relay, and/or according to any of claims 8-13 wherein the fourth switch (360) is a solid state relay, and/or according to claim 14 wherein the fifth switch (430) is a solid state relay.

## Patentansprüche

1. Batteriemanagementsystem für ein Elektrofahrzeug, das umfasst:

einen ersten Anschluss (105) zum elektrischen Verbinden einer Klemme (505) einer Batterie (500) des Elektrofahrzeugs,
einen zweiten Anschluss (110) zum elektrischen Verbinden einer elektrischen Last des Elektrofahrzeugs,
einen dritten Anschluss (115) zum elektrischen Verbinden eines Fahrgestells (600) des Elektrofahrzeugs,
eine erste Feststellungs-Schaltung (130, 230), die mit einem ersten Knoten (120) zwischen dem ersten Anschluss (105) und dem zweiten Anschluss (110) leitend gekoppelt ist und mit einem zweiten Knoten (125) mit dem dritten Anschluss (115) leitend gekoppelt ist, wobei die erste Feststellungs-Schaltung (130, 230) umfasst:
einen ersten Spannungsteiler, der eine erste Reihenschaltung mit wenigstens einem ersten Widerstand (135) und einem zweiten Widerstand (140) umfasst; **dadurch gekennzeichnet, dass** die erste Feststellungs-Schaltung (130, 230) des Weiteren umfasst:

einen ersten Schalter (145), der leitend parallel zu dem ersten Widerstand (135) gekoppelt ist, und der zwischen den ersten Knoten (120) und einen Knoten (155) zwischen dem ersten Widerstand (135) und dem zweiten Widerstand (145) gekoppelt ist, so dass, wenn der erste Schalter AN geschaltet ist, der erste Widerstand (135) kurzgeschlossen ist, und dass, wenn der erste Schalter (145) AUS geschaltet ist, der erste Widerstand (135) nicht kurzgeschlossen ist,
eine erste Messungs-Schaltung (150), die so ausgeführt ist, dass sie eine erste Spannung über den zweiten Widerstand (140) misst, wenn der erste Schalter (145) AUS geschaltet ist, und eine zweite Spannung über den zweiten Widerstand (140) misst, wenn der erste Schalter (145) AN geschaltet ist; und wobei das Batteriemanagementsystem des Weiteren umfasst:

eine Verarbeitungs-Schaltung, die so ausgeführt ist, dass sie einen Kriechwegwiderstand zwischen einer anderen Klemme (510) der Batterie (500) und dem Fahrgestell (600) des Elektrofahrzeugs auf Basis der ersten Spannung, der zweiten Spannung und einer Spannung der Batterie (500) bestimmt.

2. Batteriemanagementsystem nach Anspruch 1, wobei die Verarbeitungs-Schaltung des Weiteren so ausgeführt ist, dass sie steuert, ob der erste Schalter (145) AN oder AUS geschaltet ist.

3. Batteriemanagementsystem nach einem der Ansprüche 1 oder 2, wobei die erste Reihenschaltung des Weiteren einen dritten Widerstand (205) umfasst.

4. Batteriemanagementsystem nach einem der Ansprüche 1 bis 3, wobei
die erste Reihenschaltung des Weiteren einen vierten Widerstand (210) umfasst und die erste Feststellungs-Schaltung (230) des Weiteren einen zweiten Schalter (215) umfasst, der leitend parallel zu dem vierten Widerstand (210) gekoppelt ist und der zwischen den ersten Knoten (120) und einen Knoten (225) zwischen dem ersten Widerstand (135) und dem vierten Widerstand (210) gekoppelt ist, so dass, wenn der zweite Schalter (215) AN geschaltet ist, der vierte Widerstand (210) kurzgeschlossen ist, und dass, wenn der zweite Schalter (215) AUS geschaltet ist, der vierte Widerstand (210) nicht kurzgeschlossen ist, und
die erste Messungs-Schaltung (145) des Weiteren so ausgeführt ist, dass sie die erste Spannung über den zweiten Widerstand (140) misst, wenn der erste Schalter (145) AUS geschaltet ist und wenn der zweite Schalter (215) AUS geschaltet ist, und sie die zweite Spannung über den zweiten Widerstand (140) misst, wenn der erste Schalter (145) AN geschaltet ist und wenn der zweite Schalter (215) AN geschaltet ist.

5. Batteriemanagementsystem nach einem der Ansprüche 1 bis 4, das des Weiteren umfasst:

einen vierten Anschluss (305) zum elektrischen Verbinden der anderen Klemme (510) der Batterie (500) des Elektrofahrzeugs,
einen fünften Anschluss (310) zum elektrischen Verbinden der elektrischen Last des Elektrofahrzeugs, sowie
eine zweite Feststellungs-Schaltung (325), die mit einem dritten Knoten (315) zwischen dem vierten Anschluss (305) und dem fünften Anschluss (310) leitend gekoppelt ist und mit einem vierten Knoten (320) mit dem dritten Anschluss (115) leitend gekoppelt ist, wobei die zweite Feststellungs-Schaltung (325) des Weiteren umfasst:

einen zweiten Spannungsteiler, der eine zweite Reihenschaltung mit wenigstens einem fünften Widerstand (330) und einem sechsten Widerstand (335) umfasst,
einen dritten Schalter (340), der leitend parallel zu dem fünften Widerstand (330) gekoppelt ist, und der zwischen den dritten Knoten (315) und einen Knoten (346) zwischen dem fünften Widerstand (330) und dem sechsten Widerstand (335) gekoppelt ist, so dass, wenn der dritte Schalter (340) AN geschaltet ist, der fünfte Widerstand (330) kurzgeschlossen ist, und dass, wenn der dritte Schalter (340) AUS geschaltet ist, der fünfte Widerstand (135) nicht kurzgeschlossen ist,
eine zweite Messungs-Schaltung (325), die so ausgeführt ist, dass sie eine dritte Spannung über den sechsten Widerstand (335) misst, wenn der dritte Schalter (340) AUS geschaltet ist, und eine vierte Spannung über den sechsten Widerstand (335) misst, wenn der dritte Schalter (340) AN geschaltet ist, und

wobei die Verarbeitungs-Schaltung des Weiteren so ausgeführt ist, dass sie einen Kriechwegwiderstand zwischen der einen Klemme (505) der Batterie (500) und dem Fahrgestell (600) des Elektrofahrzeugs auf Basis der dritten Spannung, der vierten Spannung und der Spannung der Batterie (500) bestimmt.

6. Batteriemanagementsystem nach Anspruch 5, wobei die Verarbeitungs-Schaltung des Weiteren so ausgeführt ist, dass sie steuert, ob der dritte Schalter (340) AN oder AUS geschaltet ist.

7. Batteriemanagementsystem nach einem der Ansprüche 5 oder 6, wobei die zweite Reihenschaltung des Weiteren einen siebten Widerstand (350) umfasst.

8. Batteriemanagementsystem nach einem der Ansprüche 5 bis 7, wobei die zweite Reihenschaltung des Weiteren einen achten Widerstand (355) umfasst und die zweite Feststellungs-Schaltung (325) des Weiteren einen vierten Schalter (360) umfasst, der leitend parallel zu dem achten Widerstand (355) gekoppelt ist und der zwischen den dritten Knoten (315) und einen Knoten (356) zwischen dem fünften Widerstand (330) und dem achten Widerstand (355) gekoppelt ist, so dass, wenn der vierte Schalter (360) AN geschaltet ist, der achte Widerstand (355) kurzgeschlossen ist und dass, wenn der vierte Schalter (360) AUS geschaltet ist, der achte Widerstand (355) nicht kurzgeschlossen ist, und
die zweite Messungs-Schaltung (345) des Weiteren so ausgeführt ist, dass sie die dritte Spannung über den sechsten Widerstand (335) misst, wenn der dritte Schalter (340) AUS geschaltet ist und wenn der vierte Schalter (360) AUS geschaltet ist, und die vierte Spannung über den sechsten Widerstand (355) misst, wenn der dritte Schalter (340) AN geschaltet ist und wenn der vierte Schalter (360) AN geschaltet ist.

9. Batteriemanagementsystem nach einem der Ansprüche 5 bis 8, wobei die Verarbeitungs-Schaltung des Weiteren so ausgeführt ist, dass sie den Kriechwegwiderstand zwischen der anderen Klemme (510) der Batterie (500) und dem Fahrgestell (600) des Elektrofahrzeugs auf Basis der ersten Spannung, der zweiten Spannung und der dritten Spannung bestimmt.

**10.** Batteriemanagementsystem nach einem der Ansprüche 5 bis 8, wobei die Verarbeitungs-Schaltung des Weiteren so ausgeführt ist, dass sie den Kriechwegwiderstand zwischen der einen Klemme (505) der Batterie (500) und dem Fahrgestell (600) des Elektrofahrzeugs auf Basis der ersten Spannung, der dritten Spannung und der vierten Spannung bestimmt.

**11.** Batteriemanagementsystem nach einem der Ansprüche 5 bis 8, wobei
die zweite Messungs-Schaltung (345) des Weiteren so ausgeführt ist, dass sie eine fünfte Spannung über den sechsten Widerstand (335) misst, wenn der erste Schalter (145) AN geschaltet ist und/oder wenn der zweite Schalter (215) AN geschaltet ist, und
die Verarbeitungs-Schaltung des Weiteren so ausgeführt ist, dass sie den Kriechwegwiderstand zwischen der anderen Klemme (510) der Batterie (500) und dem Fahrgestell (600) des Elektrofahrzeugs auf Basis der ersten Spannung, der zweiten Spannung, der dritten Spannung und der fünften Spannung bestimmt; und/oder
wobei die erste Messungs-Schaltung (150) des Weiteren so ausgeführt ist, dass sie eine sechste Spannung über den zweiten Widerstand (140) misst, wenn der dritte Schalter (340) AN geschaltet ist und/oder wenn der vierte Schalter (360) AN geschaltet ist, und
die Verarbeitungs-Schaltung des Weiteren so ausgeführt ist, dass sie den Kriechwegwiderstand zwischen der einen Klemme (505) der Batterie (500) und dem Fahrgestell (600) des Elektrofahrzeugs auf Basis der ersten Spannung, der dritten Spannung, der vierten Spannung und der sechsten Spannung bestimmt.

**12.** Batteriemanagementsystem nach einem der Ansprüche 1 bis 11, das des Weiteren einen ersten Schütz (405), der leitend mit dem ersten Knoten (120) mit dem ersten Anschluss (105) und mit einem fünften Knoten (410) mit dem zweiten Anschluss (110) gekoppelt ist, sowie einen zweiten Schütz (410) umfasst, der leitend mit dem dritten Knoten (315) mit dem vierten Anschluss (305) und mit einem sechsten Knoten (420) mit dem fünften Anschluss (310) gekoppelt ist.

**13.** Batteriemanagementsystem nach Anspruch 12, wobei
der zweite Anschluss (110) des Weiteren zum elektrischen Verbinden einer Seite eines Zwischenkreises (550) des Elektrofahrzeugs ausgeführt ist, und
der fünfte Anschluss (310) des Weiteren zum elektrischen Verbinden einer anderen Seite des Zwischenkreises (550) des Elektrofahrzeugs ausgeführt ist,
wobei der Zwischenkreis (550) leitend mit der elektrischen Last des Elektrofahrzeugs gekoppelt ist und der Zwischenkreis umfasst:

eine erste Kapazität (555), die leitend mit einem ersten Knoten (L1) des Zwischenkreises (550) zwischen dem zweiten Anschluss (110) und der elektrischen Last des Elektrofahrzeugs und mit einem zweiten Knoten (L2) des Zwischenkreises (550) mit dem Fahrgestell des Elektrofahrzeugs gekoppelt ist,
eine zweite Kapazität (560), die leitend mit einem dritten Knoten (L3) des Zwischenkreises (550) zwischen dem fünften Anschluss (310) und der elektrischen Last des Elektrofahrzeugs und mit dem zweiten Knoten (L2) des Zwischenkreises (550) mit dem Fahrgestell des Elektrofahrzeugs gekoppelt ist, sowie
eine dritte Kapazität (565), die leitend mit dem ersten Knoten (L1) des Zwischenkreises (550) und mit dem dritten Knoten (L3) des Zwischenkreises (550) gekoppelt ist.

**14.** Batteriemanagementsystem nach Anspruch 13, das des Weiteren umfasst:

einen sechsten Anschluss (425) zum elektrischen Verbinden einer Klemme einer Niederspannungsbatterie (530), wobei die andere Klemme der Niederspannungsbatterie (530) leitend mit dem Fahrgestell des Fahrzeugs gekoppelt ist,
einen fünften Schalter (430), der leitend mit einem siebten Knoten (435) mit dem sechsten Anschluss (425) und mit dem fünften Knoten (410) zwischen dem zweiten Anschluss (110) und dem ersten Schütz (405) gekoppelt ist, sowie
eine dritte Messungs-Schaltung (455), die leitend mit dem fünften Knoten (410) zwischen dem zweiten Anschluss (110) und dem ersten Schütz (405) und mit einem achten Knoten (460) mit dem dritten Anschluss (115) gekoppelt ist, und so ausgeführt ist, dass sie eine siebte Spannung zwischen dem fünften Knoten (410) und dem achten Knoten (460) misst, wenn der fünfte Schalter (430) AN geschaltet ist,
wobei die Verarbeitungs-Schaltung des Weiteren so ausgeführt ist, dass sie steuert, dass der fünfte Schalter (430) AN oder AUS geschaltet ist, und dass sie einen Kriechwegwiderstand zwischen der einen Seite des Zwischenkreises und dem Fahrgestell des Elektrofahrzeugs auf Basis der siebten Spannung bestimmt.

**15.** Batteriemanagementsystem nach einem der Ansprüche 1 - 3, wobei der erste Schalter (145) ein Halbleiterrelais ist, und/oder nach Anspruch 4, wobei der zweite Schalter (215) ein Halbleiterrelais ist, und/oder nach einem der Ansprüche 5 bis 7, wobei der dritte Schalter (340) ein Halbleiterrelais ist, und/oder nach einem der Ansprüche 8 bis 13, wobei der vierte Schalter (360) ein Halbleiterrelais ist, und/oder nach Anspruch 14, wobei der fünfte Schalter (430) ein Halbleiterrelais ist.

## Revendications

**1.** Système de gestion de batterie pour un véhicule électrique comprenant :

une première borne (105) pour connecter électriquement une borne (505) d'une batterie (500) du véhicule électrique,
une deuxième borne (110) pour connecter électriquement une charge électrique du électrique véhicule,
une troisième borne (115) pour connecter électriquement un châssis (600) du véhicule électrique,
un premier circuit de détermination (130, 230) couplé en conductivité avec un premier nœud (120) entre la première borne (105) et la deuxième borne (110) et couplé en conductivité avec un deuxième nœud (125) à la troisième borne (115), le premier circuit de détermination (130, 230) comprenant :
un premier diviseur de tension qui comprend un premier circuit en série avec au moins une première résistance (135) et une deuxième résistance (140) ; **caractérisé en ce que** le premier circuit de détermination (130, 230) comprend en outre :

un premier commutateur (145) qui est couplé en conductivité en parallèle à la première résistance (135) et qui est couplé entre le premier nœud (120) et un nœud (155) entre la première résistance (135) et la deuxième résistance (145), de sorte que, lorsque le premier commutateur est sous tension (ON), la première résistance (135) est court-circuitée et que, lorsque le premier commutateur (145) est hors tension (OFF), la première résistance (135) n'est pas court-circuitée,
un premier circuit de mesure (150) configuré pour mesurer une première tension à travers la deuxième résistance (140), lorsque le premier commutateur (145) est hors tension (OFF), et pour mesurer une deuxième tension à travers la deuxième résistance (140), lorsque le premier commutateur (145) est sous tension (ON) ;
et dans lequel le système de gestion de batterie comprend en outre :
un circuit de traitement configuré pour déterminer une résistance de trajet de fuite entre une autre borne (510) de la batterie (500) et le châssis (600) du véhicule électrique selon la première tension, la deuxième tension et une tension de la batterie (500).

**2.** Le système de gestion de batterie selon la revendication 1, dans lequel le circuit de traitement est configuré en outre pour contrôler que le premier commutateur (145) est sous tension (ON) ou hors tension (OFF) .

**3.** Le système de gestion de batterie selon l'une quelconque de la revendication 1 ou 2, dans lequel le premier circuit en série comprend en outre une troisième résistance (205).

**4.** Le système de gestion de batterie selon l'une quelconque des revendications 1 à 3, dans lequel le premier circuit en série comprend en outre une quatrième résistance (210) et le premier circuit de détermination (230) comprend en outre un deuxième commutateur (215) qui est couplé en conductivité en parallèle à la quatrième résistance (210) et qui est couplé entre le premier nœud (120) et un nœud (225) entre la première résistance (135) et la quatrième résistance (210), de sorte que, lorsque le deuxième commutateur (215) est sous tension (ON), la quatrième résistance (210) est court-circuitée et que, lorsque le deuxième commutateur (215) est hors tension (OFF), la quatrième résistance (210) n'est pas court-circuitée, et
le premier circuit de mesure (145) est configuré en outre pour mesurer la première tension à travers la deuxième résistance (140) lorsque le premier commutateur (145) est hors tension (OFF) et lorsque le deuxième commutateur (215) est hors tension (OFF), et pour mesurer la deuxième tension à travers la deuxième résistance (140), lorsque le premier commutateur (145) est sous tension (ON) et lorsque le deuxième commutateur (215) est sous tension (ON).

**5.** Le système de batterie gestion selon l'une quelconque des revendications 1 à 4, comprenant en outre :

une quatrième borne (305) pour connecter électriquement l'autre borne (510) de la batterie (500) du véhicule électrique,

une cinquième borne (310) pour connecter électriquement la charge électrique du électrique véhicule et,
un deuxième circuit de détermination (325) qui est couplé en conductivité avec un troisième nœud (315) entre la quatrième borne (305) et la cinquième borne (310) et couplé en conductivité avec un quatrième nœud (320) à la troisième borne (115), le deuxième circuit de détermination (325) comprenant en outre :

un deuxième diviseur de tension qui comprend un deuxième circuit en série avec au moins une cinquième résistance (330) et une sixième résistance (335),
un troisième commutateur (340) qui est couplé en conductivité en parallèle à la cinquième résistance (330) et qui est couplé entre le troisième nœud (315) et un nœud (346) entre la cinquième résistance (330) et la sixième résistance (330), de sorte que, lorsque le troisième commutateur (340) est sous tension (ON), la cinquième résistance (330) est court-circuitée et que, lorsque le troisième commutateur (340) est hors tension (OFF), la cinquième résistance (330) n'est pas court-circuitée,
un deuxième circuit de mesure (325) configuré pour mesurer une troisième tension à travers la sixième résistance (335), lorsque le troisième commutateur (340) est hors tension (OFF), et pour mesurer une quatrième tension à travers la sixième résistance (335), lorsque le troisième commutateur (340) est sous tension (ON), et
dans lequel le circuit de traitement est configuré en outre pour déterminer une résistance de trajet de fuite entre l'une borne (505) de la batterie (500) et le châssis (600) du véhicule électrique selon la troisième tension, la quatrième tension et la tension de la batterie (500).

6.  Le système de gestion de batterie selon la revendication 5, dans lequel le circuit de traitement est configuré en outre pour contrôler que le troisième commutateur (340) est sous tension (ON) ou hors tension (OFF) .

7.  Le système de gestion de batterie selon l'une quelconque de la revendication 5 ou 6, dans lequel le deuxième circuit en série comprend en outre une septième résistance (350).

8.  Le système de gestion de batterie selon l'une quelconque des revendications 5 à 7, dans lequel le deuxième circuit en série comprend en outre une huitième résistance (355) et le deuxième circuit de détermination (325) comprend en outre un quatrième commutateur (360) qui est couplé en conductivité en parallèle à la huitième résistance (355) et qui est couplé entre le troisième nœud (315) et un nœud (356) entre la cinquième résistance (330) et la huitième résistance (355), de sorte que, lorsque le quatrième commutateur (360) est sous tension (ON), la huitième résistance (355) est court-circuitée et que, lorsque le quatrième commutateur (360) est hors tension (OFF), la huitième résistance (355) n'est pas court-circuitée, et
le deuxième circuit de mesure (345) est configuré en outre pour mesurer la troisième tension à travers la sixième résistance (335), lorsque le troisième commutateur (340) est hors tension (OFF) et lorsque le quatrième commutateur (360) est hors tension (OFF), et pour mesurer la quatrième tension à travers la sixième résistance (355), lorsque le troisième commutateur (340) est sous tension (ON) et lorsque le quatrième commutateur (360) est sous tension (ON).

9.  Le système de gestion de batterie selon l'une quelconque des revendications 5 à 8, dans lequel le circuit de traitement configuré en outre pour déterminer la résistance de trajet de fuite entre l'autre borne (510) de la batterie (500) et le châssis (600) du véhicule électrique selon la première tension, la deuxième tension et la troisième tension.

10. Le système de gestion de batterie selon l'une quelconque des revendications 5 à 8, dans lequel le circuit de traitement configuré en outre pour déterminer la résistance de trajet de fuite entre l'une borne (505) de la batterie (500) et le châssis (600) du véhicule électrique selon la première tension, la troisième tension et la quatrième tension.

11. Le système de gestion de batterie selon l'une quelconque des revendications 5 à 8, dans lequel
le deuxième circuit de mesure (345) est configuré en outre pour mesurer une cinquième tension à travers la sixième résistance (335), lorsque le premier commutateur (145) est sous tension (ON) et/ou lorsque le deuxième commutateur (215) est sous tension (ON), et
le circuit de traitement est configuré en outre pour déterminer la résistance de trajet de fuite entre l'autre borne (510) de la batterie (500) et le châssis (600) du véhicule électrique selon la première tension, la deuxième tension, la troisième tension et la cinquième tension ; et/ou
dans lequel le premier circuit de mesure (150) est configuré en outre pour mesurer une sixième tension à travers la deuxième résistance (140), lorsque le troisième commutateur (340) est sous tension (ON) et/ou lorsque le quatrième commutateur (360) est sous tension (ON), et
le circuit de traitement est configuré en outre pour déterminer la résistance de trajet de fuite entre l'une borne (505) de la batterie (500) et le châssis (600) du véhicule électrique selon la première tension, la troisième tension, la quatrième tension et la sixième tension.

**12.** Le système de gestion de batterie selon l'une quelconque des revendications 1 à 11, comprenant en outre un premier contacteur (405) couplé en conductivité avec le premier nœud (120) à la première borne (105) et avec un cinquième nœud (410) à la deuxième borne (110), et un deuxième contacteur (410) couplé en conductivité avec le troisième nœud (315) à la quatrième borne (305) et avec un sixième nœud (420) à la cinquième borne (310) .

**13.** Le système de gestion de batterie selon la revendication 12, dans lequel
la deuxième borne (110) est configurée en outre pour connecter électriquement un côté d'une liaison CC (550) du véhicule électrique, et
la cinquième borne (310) est configurée en outre pour connecter électriquement un autre côté de la liaison CC (550) du véhicule électrique,
dans lequel la liaison CC (550) est couplée en conductivité avec la charge électrique du véhicule électrique et la liaison CC comprend :

une première capacitance (555) couplée en conductivité avec un premier nœud (L1) de la liaison CC (550) entre la deuxième borne (110) et la charge électrique du véhicule électrique et avec un deuxième nœud (L2) de la liaison CC (550) au châssis du véhicule électrique,
une première capacitance (560) couplée en conductivité avec un premier nœud (L1) de la liaison CC (550) entre la deuxième borne (310) et la charge électrique du véhicule électrique et avec un deuxième nœud (L2) de la liaison CC (550) au châssis du véhicule électrique, et
une troisième capacitance (565) qui est couplée en conductivité avec le premier nœud (L1) de la liaison CC (550) et avec le troisième nœud (L3) de la liaison CC (550) .

**14.** Le système de gestion de batterie selon la revendication 13, comprenant en outre :

une sixième borne (425) pour connecter électriquement une borne d'une batterie basse tension (530), l'autre borne de la batterie basse tension (530) étant couplée en conductivité au châssis du véhicule,
un cinquième commutateur (430) couplé en conductivité avec un septième nœud (435) à la sixième borne (425) et avec le cinquième nœud (410) entre la deuxième borne (110) et le premier contacteur (405), et
un troisième circuit de mesure (455), couplé en conductivité avec le cinquième nœud (410) entre la deuxième borne (110) et le premier contacteur (405) et avec un huitième nœud (460) à la troisième borne (115), configuré pour mesurer une septième tension entre le cinquième nœud (410) et le huitième nœud (460), lorsque le cinquième commutateur (430) est sous tension (ON),
dans lequel le circuit de traitement est configuré en outre pour contrôler que le cinquième commutateur (430) est sous tension (ON) ou hors tension (OFF) et pour déterminer une résistance de trajet de fuite entre l'un côté de la liaison CC et le châssis du véhicule électrique selon la septième tension.

**15.** Le système de gestion de batterie selon l'une quelconque des revendications 1 à 3, dans lequel le premier commutateur (145) est un relai à semiconducteurs, et/ou selon la revendications 4 dans lequel le deuxième commutateur (215) est un relai à semiconducteurs, et/ou selon l'une quelconque des revendications 5 à 7 dans lequel le troisième commutateur (340) est un relai à semiconducteurs, et/ou selon l'une quelconque des revendications 8 à 13 dans lequel le quatrième commutateur (360) est un relai à semiconducteurs, et/ou selon la revendications 14 dans lequel le cinquième commutateur (430) est un relai à semiconducteurs.

Fig. 1

**Fig. 2**

EP 3 660 520 B1

**Fig. 3**

Fig. 4

**Fig. 5**

Prior Art

EP 3 660 520 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130027049 A1
- CN 102508038 A
- US 8884638 B2
- US 2017334295 A1
- DE 102016103883 A1
- US 2015276846 A1